Europäisches Patentamt

(18) European Patent Office

Office européen des brevets

(11) Publication number: **0 031 731**
**B2**

# (12) NEW EUROPEAN PATENT SPECIFICATION

(45) Date of publication of the new patent specification: **04.05.88**

(21) Application number: **80304755.4**

(22) Date of filing: **30.12.80**

(51) Int. Cl.⁴: **C 01 B 33/02, C 23 C 14/34, H 01 L 31/18**

(54) **Control of the hydrogen bonding in reactively sputtered amorphous silicon.**

(30) Priority: **31.12.79 US 108469**

(43) Date of publication of application:
**08.07.81 Bulletin 81/27**

(45) Publication of the grant of the patent:
**23.05.84 Bulletin 84/21**

(45) Mention of the opposition decision:
**04.05.88 Bulletin 88/18**

(84) Designated Contracting States:
**DE FR GB IT**

(56) References cited:
US-A-3 589 994
US-A-3 650 737

PHYSICAL REVIEW B, vol. 16, no. 8, 15th October 1977, pages 3556-3571 M.H. BRODSKY et al.: "Infrared and Raman spectra of the silicon-hydrogen bonds in amorphous silicon prepared by glow discharge and sputtering"

(73) Proprietor: **Exxon Research and Engineering Company**
**P.O.Box 390 180 Park Avenue**
**Florham Park New Jersey 07932 (US)**

(72) Inventor: **Moustakas, Theodore Demetri**
**42 Hilltop Avenue**
**Berkeley Heights New Jersey (US)**

(74) Representative: **Mitchell, Alan et al**
**ESSO Engineering (Europe) Ltd. Patents & Licences Apex Tower High Street**
**New Malden Surrey KT3 4DJ (GB)**

(56) References cited:
THIN SOLID STATE, vol. 58, no. 2, April 1979, page 412, J.C. ANDERSON: "Properties of amorphous silicon films sputtered in argon silane mixtures"

JOURNAL OF APPLIED PHYSICS, vol. 50, no. 11, November 1979, Part 1, pages 7034-7038 F.R. JEFFREY et al.: "Control of dihydride bond density in reactive sputtered amorphous silicon"

**0 031 731**

(58) References cited:

SOLID STATE COMMUNICATIONS, vol. 23, no. 3 July 1977, pages 155-157 T.D. MOUSTAKAS et al.: "Preparation of highly photoconductive amorphous silicon by rf sputtering"

JOURNAL OF APPLIED PHYSICS, vol. 49, no. 11, November 1978, pages 5595-5601 W.T. PAWLEWICZ: "Influence of deposition conditions on sputter-deposited amorphous silicon"

JOURNAL OF THE ELECTROCHEMICAL SOCIETY, vol. 127, no. 3, March 1980, abstract no. 196 P.M. MARTIN et al.: "Influence of deposition conditions on the hydrogen composition of sputtered a-Si:H alloys"

AIP Conference Proceedings, Series Editor:Hugh C.Wolfe No.31"Structure and Excitations of Amorphous Solids",American Institute of Physics, New York 1976, pp. 296,297

## Description

The present invention relates to the production of amorphous silicon and more particularly reactively sputtered hydrogenated amorphous silicon in which the hydrogen is bonded selectively in monohydride and polyhydride configurations.

The two principal methods of producing hydrogenerated amorphous silicon are the glow discharge decomposition of silane and reactive sputtering in a mixture of argon and hydrogen. Hydrogenated amorphous silicon films produced by these these techniques are known to have differences in optical and electronic properties. Those of the art attribute some of these distinctions to the differences in the bonding configuration of hydrogen into the amorphous silicon network. For example, when hydrogen bonds in polyhydride configurations, it introduces electronic defects in the gap of the semi-conductor and also widens the optical gap of the material by modifying the valence and possibly the conduction bands. In view of these observations previous efforts have attempted to identify the deposition parametres which controls the bonding of hydrogen into the amorphous network.

The silicon-hydrogen bonding characteristics in photoconductive amorphous silicon are conventionally explained in relation to the local environments of the incorporated hydrogen. Those of the art believe that the hydrogen can be present either in the mono-hydride SiH form, isolated dihydride $SiH_2$ units, coupled dehydride $SiH_2$ units, higher order poly-hydrides such as $SiH_3$, or combinations thereof. For purposes of the present application, the term polyhydride will be used to collectively define all silicon-hydrogen bonding forms other than the monohydride, SiH. Typically, infrared absorbtion or vibration spectra data are used to analyze the bonding characteristics of the silicon film. An analysis of the silicon-hydrogen vibrational spectra indicates the density of silicon to hydrogen bonding of the monohydride and polyhydride forms.

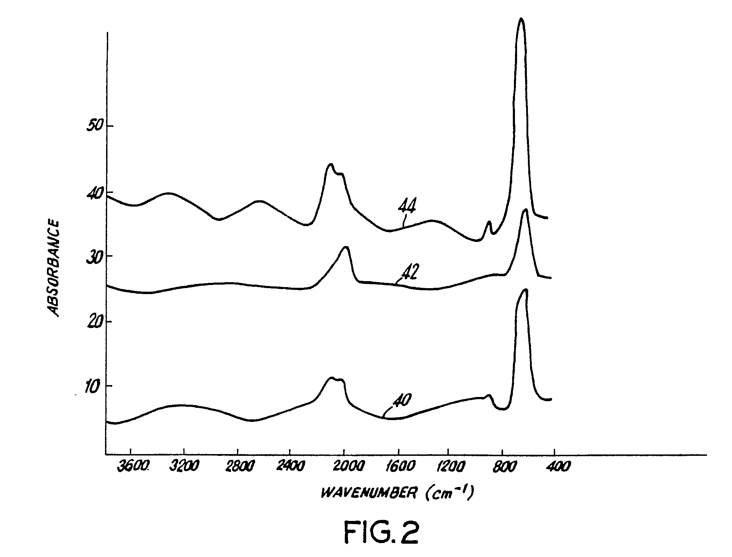

Referring momentarily to the drawings, an illustration of an infrared absorption spectra is shown in Figure 2. The three absorption bands are identified as the stretching ($\sim$2000 $cm^{-1}$), bending ($\sim$900 $cm^{-1}$) and wagging ($\sim$600 $cm^{-1}$) modes of SiH and SiHx groupings. The presence of polyhydrides in the film is evidenced by the bending modes, whose origin are forced opposing changes in the angles between Si-H bonds within $SiH_2$ and $SiH_3$ groups. Contrary to the stretching and wagging vibrations the bending modes are absent when the hydrogen is bonded only in monohydride configurations. For purposes of the present invention, the bonding mode evidenced at 2000 $cm^{-1}$ is the stretching vibration of monohydride groups and the bonding mode evidenced at 2100 $cm^{-1}$ is the stretching vibration of the polyhydride groups. The integrated absorption under these two modes provides a measure of the density of monohydride and polyhydride bonds respectively. Controlling the relative density of the monohydride and polyhydride forms of bonding is believed to be an important parameter in producing favorable electronic properties in photoconductive amorphous silicon. The present invention embraces deposition techniques for producing reactively sputtered photo-conductive amorphous silicon films having controlled monohydride and polyhydride bond densities. A positive voltage bias applied to the substrates during the sputter deposition increases the relative density of monohydride to polyhydride bonds in the resultant film.

The art has demonstrated the ability to control the relative density of monohydride and polyhydride bonds in amorphous silicon produced by glow discharge decomposition of silane. For example, Brodsky et al in a technical publication entitled "Infrared and Raman spectra of the silicon-hydrogen bonds in amorphous silicon prepared by glow discharge and sputtering" teach the basic glow discharge deposition parameters which control the bonding of hydrogen. Films produced at low silane pressure ($\sim$0.1 Torr) and high temperature (Ts$\sim$250°C) contain primarily monohydrides (The stretching vibration is centred around 2000$cm^{-1}$). Films produced at low temperatures (Ts$\sim$25°C) and high silane pressure ($\sim$1 Torr) contain primarily polyhydrides (The stretching vibration is centred around 2100 $cm^{-1}$).

Brodsky et al, in *Physical Review*, v. 16, No. 8, 10/77 and Freeman et al, in *Physical Review* v. 16, No. 8, 10/15/78, teach that for sputter deposited amorphous silicon the stretching vibration is always a doublet, which together with the existence of the bending mode at 900 $cm^{-1}$ teach that the sputtered films always contain a mixture of monohydride and polyhydride bonding configurations. However, neither document discloses how to achieve predetermined control of the bonding of hydrogen in sputtered hydrogenated amorphous silicon so as to decrease the polyhydride bond density. *Physical Review* B, volume 16, number 8, 15th October, 1977, also discloses applying a voltage bias to the substrate but the bias is a negative, RF bias of −50 Volts. One technique for altering the densities of the monohydride and polyhydride bonds is set forth by F. R. Jeffrey et al in a U.S. Government report under Contract number W—7405—eng—82 wherein a change in the relative density of monohydride to dihydride bonding was noted for films sputtered at different power levels. In this connection, reference is also directed to Journal of Applied Physics, Volume 50, No. 11, November 1979, pages 7034-7038, F. R. Jeffrey et al, in which a layer of amorphous silicon containing monohydrides and dihydrides is formed on a substrate by reactive sputtering in the pressure of atomic hydrogen forming a partial pressure. A decrease in the dihydride bond density is achieved by increasing the radio frequency sputtering power.

According to the present invention there is provided a method for producing, by reactive sputtering in the presence of atomic hydrogen forming a partial pressure, a layer of amorphous silicon containing monohydrides and polyhydrides, characterised by the step of applying from an external voltage source, concurrently with the with the reactive sputtering, a positive DC voltage bias to the layer so as to raise the potential of said layer, in the presence of the reactive sputtering, in the positive sense · and thereby decrease the polyhydride bond density of said layer.

The invention will be better understood from the following description given, by way of example, with reference to the drawings in which:—

Figure 1 is a diagrammatic illustration of a deposition system for producing amorphous silicon films in accordance with one way of performing the present invention; and

Figure 2 is a graphic plot of absorption versus wavelength, commonly known as an Infrared Absorption Spectra, illustrating the bonding vibration spectra for several amorphous silicon films.

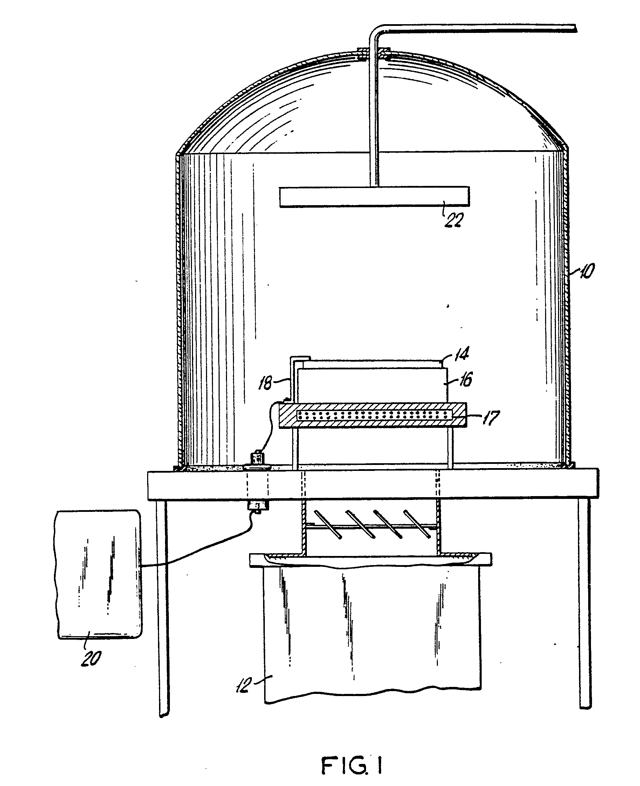

The present invention concerns a method for reactively sputtering amorphous silicon films having a controlled monohydride and polyhydride bonding density. To illustrate this invention, Figure 1 shows a sputtering apparatus adapted to provide voltage biasing on a substrate to be coated. Referring to the drawing, a vacuum chamber 10 is capable of being evacuated by pumping means 12, preferably to a pressure of about $10^{-7}$ torr. Substrate(s) 14 is secured to platform 16 which serves simultaneously as a substrate support and an anode electrode. In general, substrate 14 may comprise any material capable of withstanding temperatures of about 400°C. For electronic applications however, substrate 14 preferably comprises a material having a coating surface devoid of defects of the order of about a micrometre in size and free of materials which may migrate into the silicon to the detriment of its semiconductor properties. In many embodiments, substrate 14 may comprise a dielectric material such as glass which would electrically insulate the coating surface ·from the bias platform. For such embodiments, substrate 14 is typically coated with a conductive layer such as a metallic thin film, then secured to platform 16 by conductive securing means, here shown at 18. The substrates used for infrared optical measurements are single crystal Si wafers polished on both sides. Chamber 10 is then closed and evacuated to a pressure preferably about or below $10^{-7}$ torr.

A voltage supply 20, capable of supplying positive voltage, is coupled to supply as bias voltage to platform 16 and substrate(s) 14. Platform 16 is electrically isolated from surrounding support structures which are typically held at ground potential. Voltage supply 20 is capable of supplying a positive potential of up + 100 volts to the substrate, measured relative to ground potential. The evacuated chamber is backfilled with an inert gas such as argon to bring the steady state pressure of chamber 10 into a range suitable for sputtering, typically between 5 m torr (666,5 mPa) 50 m torr (6665 mPa), preferably between 5 m torr (666,5 mPa) and 20 m torr (2666 mPa). Alternatively, the argon backfilling may be interrupted and the chamber re-evacuated to high vacuum and subsequently backfilled to sputtering pressures. This process, repeatable to advantage, assures the removal of residuary atmosphere.

Hydrogen is fed into the vacuum chamber such that the partial pressure of hydrogen ranges from $1 \times 10^{-4}$ torr $(133,3 \times 10^{-4}$ Pa) to $5 \times 10^{-3}$ torr $(666,5 \times 10^{-3}$ Pa). As known to those of the art, the hydrogen constitutes the reactive sputtering gas which will be decomposed to its atomic state and be incorporated into the resultant amorphous silicon film. In many device embodiments, it is desirable to provide an extrinsic doping material to alter the semiconductor characteristics of the silicon. Doping gases such as phosphine or diborane, may be added prior to or during the sputter deposition to provide a number of device configurations, each well known in the art, such gases forming partial pressures ranging from about $5 \times 10^{-6}$ torr $(666,5 \times 10^{-6}$ to about $5 \times 10^{-5}$ torr $(666,5 \times 10^{-5}$ Pa) for example.

Throughout the deposition, the substrate(s) is maintained at a temperature ranging from 200°C to 400°C. Heater element 17 here shown as below and proximate to platform 16 and substrate(s) 14, may comprise any of a number of heating means capable of sustaining the aforedescribed requisite substrate temperature. Sputter deposition is then initiated by conventional capacitive coupling of radio frequency, hereinafter RF, power to the partial pressures of gases proximate to an anode and cathode electrode. The cathode comprises a polysilicon target 5″ in diameter, here shown at 22. The anode comprises the assembly of platform 16, substrate(s) 14 and securing means 18. As discussed earlier, the anode assembly is maintained at a predetermined potential positive relative to ground, typically in the range O to + 100 volts. The RF (voltage power) supplied to the cathode assembly is typically in the range from 100 watts to 500 watts for an anode-to-cathode spacing of 4.5 centimetres, resulting in a deposition rate of between 2 Å/second and 4 Å/second. An anode-to-cathode spacing of substantially 5.0 cm would also be suitable for the supplied voltage power range indicated. During the sputter deposition process, hydrogen is dissociated within the sputtering plasma. Atomic hydrogen is incorporated into the silicon film in varying forms. Using conventional sputtering techniques, wherein the substrates are maintained at ground potential or allowed to self-bias from the charging effect of the plasma, the incorporated hydrogen is bonded to the silicon in both the monohydride and polyhydride form as taught by the prior art. Referring now to Figure 2, trace 40, the conventional deposition techniques result in a film having vibrational specra for silicon-hydrogen bonding which demonstrate both monohydride characteristic peaks at 2000 $cm^{-1}$ and polyhydride characteristic peaks at 2100 $cm^{-1}$. This attribution is also supported by the existence of the bending mode at 900 cm$^{-1}$. Those of the art believe that the presence of both bonding forms is detrimental to the electronic properties of the semi-conductor. In contrast, the present invention provides control of the density of the monohydride and polyhydride bonds. Typically, a positive voltage is applied to the substrate during the deposition process so that the potential of the layer is raised to a potential level which is within the range from ground potential to +80 volts. In one embodiment, the voltage value selected is +80 volts. Biasing the substrate during the reactive sputter deposition has been shown to control the formation of silicon-hydrogen bonds. The silicon film deposited onto the positively biased substrate showed a substantial decrease in the density of polyhydride bonding. The bonding vibration spectra, shown at trace 42, evidences a substantial decrease in the amplitude of the polyhydride characteristic peaks at 2100 cm$^{-1}$ and 900 cm$^{-1}$ as compared to the conventionally sputtered silicon film spectra of trace 40. The positively biased film also evidences a corresponding increase in the amplitude of the monohydride characteristic peak at 2000 cm$^{-1}$. A comparison of trace 40 and trace 42 reveals that the aforedescribed positive bias deposition technique virtually eliminates the presence of polyhydride bonding in the resultant film and correspondingly increases the density of monohydride bonding. A further analysis of the hydrogen content of the film indicates the total hydrogen content of the film demonstrates little or no change relative to an unbiased film.

In another test not forming part of this invention, a negative voltage bias of about −100 volts is applied to the substrate(s) during the reactive sputtering. An analysis of the resultant film reveals a decrease in the density of monohydride bonds and a corresponding increase in the density of polyhydride bonds. A bonding vibration spectra, shown as trace 44, evidences a substantial decrease in the monohydride characteristic peak at 2000 cm$^{-1}$ and a corresponding increase for the polyhydride characteristic peaks at 2100 cm$^{-1}$, as compared to the control sample having a substrate maintained at ground bias, shown as trace 40.

## Claims

1. A method for producing, by reactive sputtering in the presence of atomic hydrogen forming a partial pressure, a layer of amorphous silicon containing monohydrides and polyhydrides, characterised by the step of applying from an external voltage source, concurrently with the reactive sputtering, a positive direct current voltage bias to the layer so as to raise the potential of said layer, in the presence of the reactive sputtering, in the positive sense and thereby decrease the polyhydride bond density of said layer.

2. A method according to claim 1, characterised in that said bias voltage raises the potential of said layer to a potential level which is within the range from ground potential to 80 volts.

3. A method according to either of claims 1 and 2, characterised in that said sputtering is further defined as radio frequency sputtering from a silicon cathode onto a biased substrate serving as an anode having an anode-to-cathode spacing of substantially 5.0 cm.

4. A method according to claim 3 as appended to claim 2 for producing a photoconductive amorphous silicon film having controlled monohydride bond density, characterised in that said substrate is maintained at a temperature in the range from 200°C to 400°C and said sputtering is accomplished in argon and hydrogen having partial pressures in the range from 5 m Torr to 50 m Torr (666,5 mPa to 6665 mPa) and from $1 \times 10^{-4}$ to $5 \times 10^{-3}$ Torr ($133,3.10^{-4}$ to $666,5.10^{-3}$Pa) respectively and having a radio frequency sputtering power of between 100 watts and 500 watts.

## Patentansprüche

1. Verfahren zur Erzeugung einer Schicht von amorphem Silicium mit einem Anteil von Monohydriden und Polyhydriden durch reaktive Zerstäubung in Anwesenheit von atomarem Sauerstoff, der einen Partialdruck bildet, dadurch gekennzeichnet, daß von einer externen Spannungsquelle gleichzeitig mit dem reaktiven Zerstäuben eine positive Gleichstrom-Vorspannung an die Schicht gelegt wird, um das Potential der Schicht bei dem reaktiven Zerstäuben im positiven Sinne zu erhöhen und dadurch die Polyhydrid-Bindungsdichte der Schicht herabzusetzen.

2. Verfahren nach Anspruch 1, dadurch gekennzeichnet, daß die Vorspannung das Potential der Schicht auf einen Potentialwert erhöht, der im Bereich von Erdpotential bis 80 Volt liegt.

3. Verfahren nach Anspruch 1 oder 2, dadurch gekennzeichnet, daß das Zerstäuben ein Hochfrequenzzerstäuben von einer Siliciumkathode auf ein mit einer Vorspannung belegtes Substrat ist, das als Anode dient und wobei der Anoden-Kathoden-Abstand im wesentlichen 5,0 cm beträgt.

4. Verfahren nach Anspruch 3 in Abhängigkeit von Anspruch 2 zur Erzeugung einer photoleitfähigen, amorphen Silicium-schicht mit einer gesteuerten Monohydrid-Bindungsdichte, dadurch gekennzeichnet, daß das Substrat auf einer Temperatur im Bereich von 200°C bis 400°C gehalten wird und daß das Zerstäuben mit Argon und Wasserstoff erreicht wird, die Partialdrücke im Bereich von 5 mTorr bis 50 mTorr (666,5 mPa bis 6666,5 mPa) haben und wobei eine HF-Zerstäubungsleistung von zwischen 100 Watt und 500 Watt angewendet wird.

## Revendications

1. Procédé pour produire, par pulvérisation réactive en présence d'hydrogène atomique formant une pression partielle, une couche de silicium amorphe contenant des monohydrures et des polyhydrures, procédé caractérisé par l'étape consistant à appliquer à partir d'une source de tension électrique externe, en même temps que la pulvérisation réactive, une tension continue de polarisation positive à la couche, de façon à élever le potentiel de ladite couche, en présence de la pulvérisation réactive, dans le sens positif et à diminuer ainsi la densité des liaisons de type polyhydrure dans ladite couche.

2. Procédé selon la revendication 1, caractérisé en ce que ladite tension électrique de polarisation élève le potentiel de ladite couche pour le porter à un niveau de potentiel se situant dans l'intervalle compris entre le potentiel de masse ou de terre et 80 volts.

3. Procédé selon l'une ou l'autre des revendications 1 et 2, caractérisé en ce que cette pulvérisation se définit également comme étant une pulvérisation à haute fréquence (HF) à partir d'une cathode de silicium sur un substrat polarisé servant d'anode, avec une distance de 5,0 cm sensiblement entre l'anode et la cathode.

4. Procédé selon la revendication 3, en liaison avec la revendication 2, pour produire une pellicule de silicium amorphe photoconducteur présentant une densité réglée des liaisons de type monohydrure, caractérisé en ce qu'on maintient ce subtrat à une température de 200°C à 400°C et qu'on effectue la pulvérisation dans de l'argon et de l'hydrogène ayant des pressions partielles de 5 m torrs à 50 m torrs (666,5 mPa à 6665 mPa) et de $1 \times 10^{-4}$ à $5 \times 10^{-3}$ torr ($133,3 \times 10^{-4}$ à $666,5 \times 10^{-3}$ Pa) respectivement, avec une énergie de pulvérisation à haute fréquence comprise entre 100 watts et 500 watts.

FIG. 1

1

FIG.2